# EUROPEAN PATENT SPECIFICATION

(11) **EP 1 059 713 B1**
(45) Date of publication and mention of the grant of the patent: **03.08.2005**
(21) Application number: 00112060.9
(22) Date of filing: 05.06.2000
(51) Int. Cl.: G02B 27/09, H01S 5/40

(54) **Method and device for conditioning the light emission of a laser diode array**
Verfahren und Vorrichtung zur Konditionierung der Lichtemission eines Vielfachdiodenlasers
Méthode et dispositif pour le conditionnement de la lumière de sortie d'un multiple laser à diode

(30) Priority: 08.06.1999 IT MI991271
(43) Date of publication of application: 13.12.2000
(73) Proprietor: BRIGHT SOLUTIONS SOLUZIONI LASER INNOVATIVE S.R.L, Cura Carpignano (PV) (IT)
(72) Inventor: Piccinno, Giuliano, 27028 San Martino Siccomario (Pavia) (IT); Agnesi, Antoniangelo, 27100 Pavia (IT)
(74) Representative: Ripamonti, Enrico

(56) References cited:
- WO-A-98/19202
- US-A- 5 787 107
- US-A- 5 805 748
- US-A- 5 808 803
- US-A- 5 825 551
- US-A- 5 887 096

## Description

This invention relates to a method of conditioning, or suitably modifying, the spatial distribution of the laser light emission of a array of power laser diodes (defining a laser diode bar) in order to optimize the use of the resultant laser beam emitted by said array, in accordance with the main claim. The invention also relates to a device for implementing the aforesaid method.

A laser generator of laser diode bar type is known to require optimization for proper use; for example if using optical fibres, the coupling efficiency in coupling such a device to a multimodal optical fibre has to be optimized. This requirement arises from the fact that light emission by a laser diode bar results from the compounding of a plurality of laser beams each emitted by a corresponding power diode of the laser diode array. By virtue of the geometrical characteristics of this array, each beam tends to open as a "fan" and has hence to be suitably conditioned in order for the laser beam resulting from the compounding of all the individual laser beams to attain the correct dimensions (substantially point-like on a target) and angular aperture for its insertion into an optical fibre.

Bars of high power laser diodes also frequently require devices for their coupling to the multimodal optical fibre to facilitate their use in various applications in which it is preferable to physically separate the bar from the object onto which the laser is to be applied. This ensures, inter alia, a better protection of the bar itself, this often being an element of merit in the architecture of the laser source, while at the same time achieving a modular system with a simple connection via optical fibre which for example facilitates work required for replacing the bar itself, or for coupling several laser beam generating bars to this fibre.

The difficulty of implementing a method for efficiently transferring light energy from the bar to the optical fibre (and of providing a corresponding device) derives from the emission characteristic (or modality) of the bar which, as stated, is strongly asymmetrical. Its individual constituent emitters are aligned along a first spatial axis X, they Y are rectangular in shape, with that side along the second axis Y (perpendicular to X) much shorter than that along the X axis, and they emit light along a third axis Z (perpendicular to X and Y).

To quantify the concept of spatial quality of a laser beam of wavelength λ, normally the product Q = πθW/λ is evaluated for the angle of divergence (associated with diffraction) θₓ and θ_{y} in each of the two directions X, Y, and the corresponding characteristic dimension W_{X} and W_{Y} of the light distribution in the plane perpendicular to the axis of propagation in which the area of this distribution is a minimum. The significance of the merit parameter Q (spatial quality related in known manner to brightness) therefore represents the ratio of the real beam divergence, θ, to the theoretical minimum divergence λ/(πW) which it can possess by virtue of diffraction, from which it follows that Q ≥ 1. The directions X and Y can be associated with a characteristic brightness, inversely proportional to Q_{X} and Q_{Y} respectively.

For example, in the emission from a single bar element, Q_{Y} is close to 1 and Q_{X} = 20-30.

In any event, the overall emission along the X direction, achieved by incoherently superposing the emissions of the various constituent diodes (normally > 10) of a bar, is substantially worse in terms of spatial quality and brightness (Q_{X} > 1000) than the entire distribution in the X direction (Q_{Y} equal to about 1), where the emitter beams do not mix.

This means that the distribution of the light emitted by a laser diode bar can be easily focused in the Y direction but is difficult to focus on a small dimension in the X direction with a focusing angle adequate for example for efficiently propelling (ie inserting) the laser beam into the optical fibre.

Even in direct power bar applications (ie those not requiring the use of optical fibres for light transportation) there remains the problem of spatial quality of the laser beam. In this respect, it is often desirable for the laser light not only to be focusable within sufficiently small dimensions, but also to reasonably remain within these dimensions for a certain length along its axis of propagation.

WO 98 19 202 and US 5 805 748 disclose a device and a method according to the pre-characterising portion of claim 1 and 4.

An object of this invention is to provide a method for modifying the original emission distribution of a laser bar in order to equalize its spatial quality (and hence brightness) in the X and Y directions in the case of direct applications, and its coupling efficiency in an optical fibre.

A further object is to provide a device for implementing the aforesaid method which is of low constructional and operating costs.

These and further objects which will be apparent to an expert of the art are attained by a method and device in accordance with the accompanying claims. The invention is defined in claims 1 and 4. Embodiments of the invention are set out in the dependent claims.

The invention will be more apparent from the accompanying drawing, which is provided by way of non-limiting example and on which:
Figure 1 is a schematic view of a device of the invention taken from above;
Figure 2 is a side view of the device of Figure 1;
Figure 3 is a section on the line 3-3 of Figure 1;
Figure 4 is a section on the line 4-4 of Figure 1;
Figure 5 is a section on the line 5-5 of Figure 1;
Figure 6 is a schematic view from above showing a first device for focusing the laser beam leaving the device of the invention;
Figure 7 is a side view of the device of Figure 6;
Figure 8 is a schematic view from above showing a second device for focusing the laser beam leaving the device of the invention;
Figure 9 is a side view of the device of Figure 8;
Figure 10 is a view from above showing a variant of the device of the invention associated with the focusing device of Figures 6 and 7;
Figure 11 is a side view of the device of Figure 10.

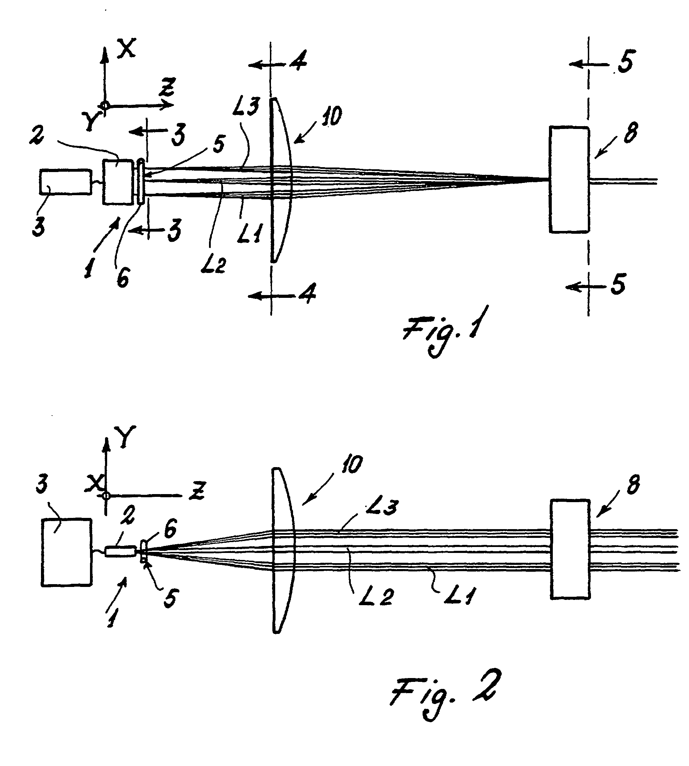

In Figures 1, 2, 6, 7, 8, 9, 10, 11 the cartesian axes are shown in order to clarify the description. Furthermore the focusing devices of Figures 6 to 11 coupled to the device of the invention are known per se.

With reference to Figures 1 to 5, the device of the invention is shown associated with a laser generator 1 comprising a bar or array 2 of power diodes providing continuous or pulsating laser light emission. The bar 2 is powered by a usual unit 3 for electrically powering said bar and for controlling its operating temperature. The bar 2 is of known form. It is of rectangular parallelepiped shape and, with reference to the cartesian axes shown in Figures 1 and 2, extends along the X and Y axes. The laser beams from the power diodes are emitted in the direction of the Z axis. As can be seen from the figures, and as is the norm, the bar 2 extends along the X axis further than along the Y axis.

For greater clarity of explanation, this description will consider a bar consisting of three individual emitters or three emitter groups, to which there correspond three laser beams L1, L2, L3. This consideration serves only to facilitate the description of the invention, and in no way represents a limitation on the method and device of the invention.

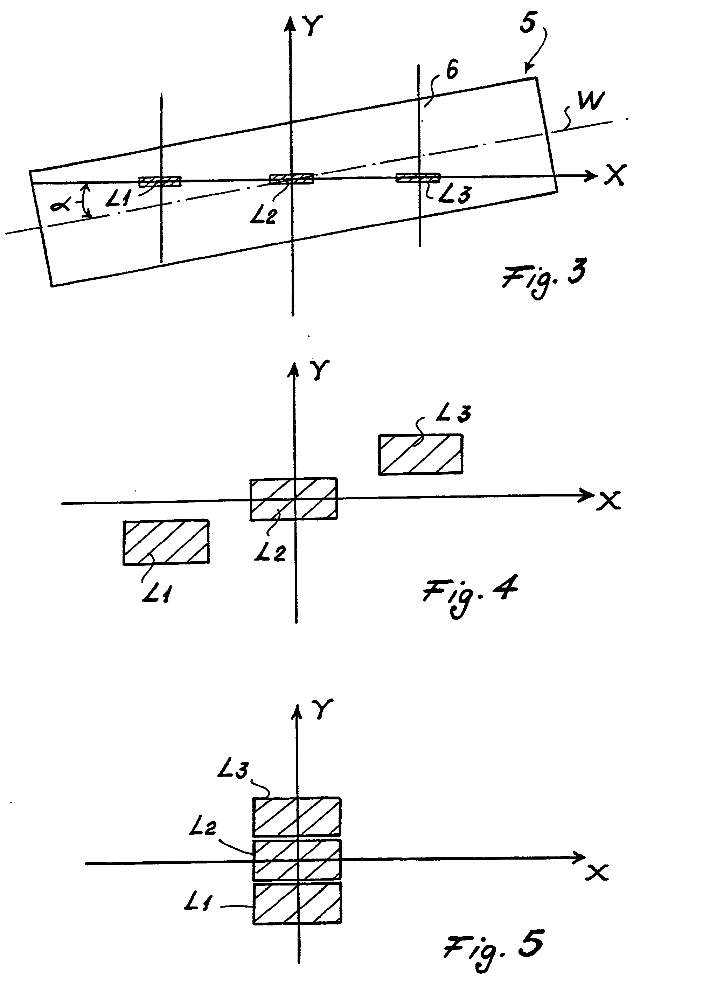

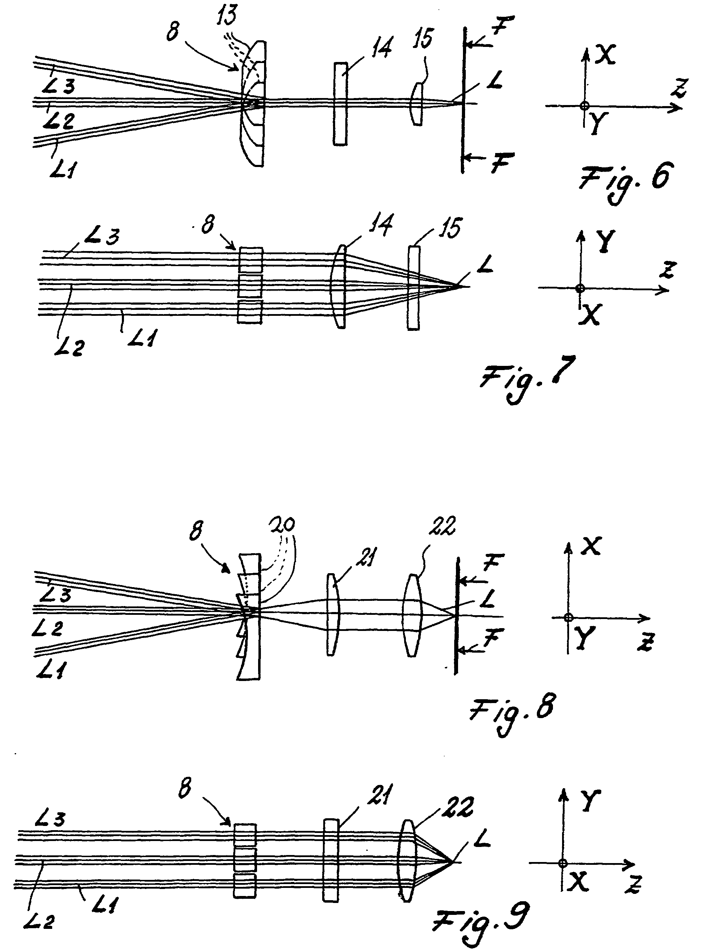

In front of the bar 2 there is positioned a separator member 5 comprising for example a cylindrical microlens 6 or a lens having a dioptric power other than zero along only one of the directions perpendicular to the axis of propagation of the laser beam or of the light in general. It has a substantially rectangular cross-section and extends along a major axis W. This microlens is suitably inclined to the bar 2 such that its axis A forms an angle α to the plane of the X axis, as shown in Figure 3. The purpose of the member 5 is to collimate the beams L1, L2 and L3 (of substantially blade-shaped cross-section) in the direction of the Y axis, their axis of propagation being shifted angularly in the direction of the Y axis (visible in Figures 2 and 4) to an extent depending on the position occupied by each individual emitter in the bar 2, on the basis of known geometrical optics relationships.

As stated, the axis W of the member 5 is inclined to the plane of the X axis by an angle α for example of between 0.1° and 5°. In order to avoid movements of the beams L1, L2, L3 along the Y axis which are too small, the angle α should not fall below too small a value (for example 0.05°); this angle in any event depends on the planarity of the bar 2 along the X axis.

The device of the invention also comprises a recombining member 8 spaced from the member 5. Between the two there can be inserted (as in the embodiment of Figures 1 and 2) a spherical lens 10. The purpose of the recombining 8 member is to make the propagation directions of the centroids of the individual beams L1, L2 and L3 perfectly parallel, by aligning them in the direction of the Y axis (or along it), as shown in Figure 5.

Downstream of the member 8, the image of the bar emission conditioned in this manner has its spatial quality (and hence brightness) equalized in the X and Y directions, and can hence be focused in optimal manner with minimum divergence, for direct applications or for coupling to an optical fibre 12. In this respect, if N is the number of beams, the now conditioned spatial distribution has Q'_{Y} = NQ_{Y} and Q'_{X} = Q_{X}/N, with Q'_{X} = Q'_{Y}, the optimal choice for the number of beams hence being N = √(Q_{X}/Q_{Y}).

By way of example, four possible arrangements for the recombining member 8 are described hereinafter with reference to Figures 6 to 11.

In the embodiment of Figures 6 and 7, the member 8 comprises a plurality of flat-convex cylindrical lenses of positive focal length 13, adjacent on each other, their centres being positioned along an axis lying in a plane perpendicular to the Z axis and inclined to the Y axis to make the propagation directions of the centroids of the beams L1, L2 and L3 leaving the member 8 parallel to the Z axis, in accordance with geometrical optics relationships.

In the figures under examination, two cylindrical lenses 14 and 15 are positioned at a suitable distance from the member 8 such that the image of the beams L1, L2 and L3, newly conditioned by the member 8, is focused in the two directions X and Y in one and the same plane F-F with dimensions defined on the basis of the application of the resultant laser beam leaving these lenses. For example, in order for the beam L to be able to be inserted into an optical fibre 50, this beam must be focused within the fibre core, with an entry cone contained within the acceptance cone of the optical fibre.

In the figures under examination, the lens 10 has a focal length F and is positioned at a distance F from the member 5 so as to collimate the beams emitted by the laser diodes and form on the recombining member 8, also positioned at a distance F from the lens, a figure consisting of an image of the individual beams aligned in the direction of the Y axis (see Figure 5).

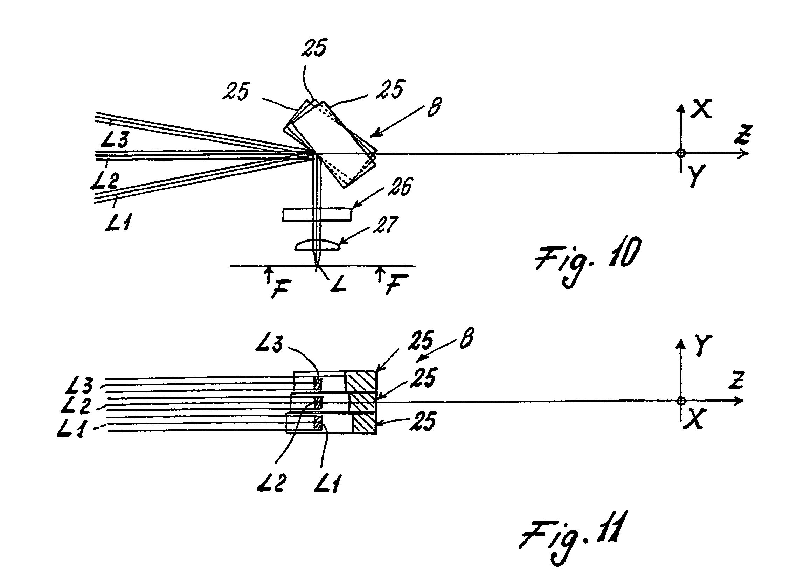

In the embodiment shown in Figures 8 and 9, the member 8 comprises a plurality of flat-concave cylindrical lenses of negative focal length 20, their centres being positioned on a straight line lying in a plane perpendicular to the Z axis and inclined to the Y axis to make the propagation directions of the centroids of the beams L1, L2 and L3 leaving the member 8 parallel to the Z axis.

As in the case of Figure 6 and 7, in the figures under consideration the lens 10 and the focusing lenses 21 and 22 are also provided, their purpose being identical to that of the aforedescribed lenses 14 and 15. In this case, the lens 21 is a cylindrical lens the focal length and position of which are chosen to collimate the newly conditioned laser beam in the X direction with a suitable direction, in such a manner as to obtain in the focal plane of the spherical lens 22 a light distribution with defined dimensions in the X and Y direction.

In Figures 10 and 11 the member 8 comprises a plurality of flat mirrors 25, the normals of which are progressively rotated (in advancing along an axis parallel to the Y axis) parallel to the X-Z plane. These mirrors deflect the laser beams L1, L2 and L3 in a direction perpendicular to the Z axis, and hence along the X axis, where lenses 26 and 27 similar to the lenses 14 and 15 of Figures 6 and 7 are positioned. Figure 11 shows the cross-section through the beams L1, L2 and L3 on the lens 26. The lenses 26 and 27 operate as the lenses 14 and 15, and consequently reference should be made to the description of these latter.

Again in the figures under examination, the beams L1, L2 and L3 strike the lens 10 (not shown) positioned between the member 8 and the member 5.

Using the member 8 as represented in one of the aforedescribed Figures 6 to 11, the entry plane of a multimodal optical fibre 50 can be presented with a virtually square light distribution, with similar and opposite X and Y dimensions, and divergence angles in the two perpendicular directions which are compatible with the characteristic acceptance angle. This enables light to be efficiently transferred from the laser diode bar to the optical fibre.

## Claims

1. A method for conditioning the light emission of a laser generator (1) comprising an array (2) of laser diodes to equalize brightness along a first axis in the direction (X) of the array (2) and along a second axis in the direction (Y) perpendicular thereto, said conditioning being such as to enable optimal use of the laser beam (L) resulting from the compounding of the individual beams (L1, L2, L3) emitted by said laser diodes, for example for its optimal coupling to an optical fibre (50), said laser diodes being positioned side by side along the first spatial axis (X) perpendicular to which the individual laser beams are emitted along a third axis (Z), the method comprising the following steps: a) separating by deflection the laser beams (L1, L2, L3) emitted by the laser diodes, said separation taking place in proximity to the laser diode array; b) shifting angularly relatively. To each other within the plane defined by the second and third axis (Y, Z) to convey at least the adjacent laser beams (L1, L2, L3) emitted by said laser diode array (2) into different spatial planes; c) recombining said beams (L1, L2, L3) in different planes along the second axis (Y), perpendicular to the axis (X) along which the laser diodes lie by deflecting the beams so that the centroids of the beams are aligned along the second axis (Y) direction and propagate in parallel directions, and d) collimating said laser beams into a resultant single laser beam (L),**characterised by** comprising a step e) of collimating the beams along the second axis direction (Y) between said step b) of conveying and said step c) of recombining.

2. A method as claimed in claim 1, **characterised in that** following the recombining of the laser beams (L1, L2, L3) emitted by the laser diode array (2), said beams (L1, L2, L3) are propagated along the said emission direction (Z).

3. A method as claimed in claim 1, **characterised in that** following the recombining of the laser beams (L1, L2, L3) emitted by the laser diode array (2), said beams (L1, L2, L3) are propagated along a direction perpendicular to the emission direction (Z).

4. A device for conditioning the light emission of a laser generator (1) comprising a laser diode array (2) having a rectangular parallelepiped body extending mainly along a principal spatial axis (X) and to a lesser extent along a second axis (Y) perpendicular to this latter, the laser beams (L1, L2, L3) being emitted by said diodes along a third axis (Z) perpendicular to said axes (X, Y), said device comprising, for said laser beams (L1, L2, L3), separator and deflector means (5) positioned in proximity to the laser diode array (2) and arranged to shift angularly relatively to each other said beams and to convey said beams into different spatial planes parallel to the plane defined by the aforesaid first and third axis (X, Z), and recombining means (8) arranged to deflect said beams so that their centroids propagate side-by-side along an axis parallel to the second axis, said laser beams (L1, L2, L3) being then focused by focusing means (14, 15; 21, 22; 26, 27) in the focal plane,**characterised in that** a lens (10) is positioned between the separator means (5) and the recombining means (8), said lens (10) having focal length F in the second direction (Y) and being positioned at a distance F from said separator and deflector means (5) so as to collimate along the second direction (Y) the beams emitted by the laser diodes.

5. A device as claimed in claim 4, **characterised in that** the separator and deflector means are a lens having a dioptric power other than zero along only one of the directions perpendicular to the axis of propagation of the laser beam.

6. A device as claimed in claim 5, **characterised in that** the lens (6) has its axis of symmetry (W) inclined to the plane defined by the first and third axis (X, Z).

7. A device as claimed in claim 4, **characterised in that** the recombining means (8) comprise a plurality of adjacent flat-convex cylindrical lenses (13) of positive focal length with their centres positioned along an axis lying in a plane perpendicular to the axis (Z) and inclined to the second axis (Y), said lenses (13) being placed along the third axis (Z) in a position where the beams are aligned along the second axis (Y).

8. A device as claimed in claim 4, **characterised in that** the recombining means (8) comprise a plurality of superposed flat-concave cylindrical lenses (20) of negative focal length with their centres positioned along an axis lying in a plane perpendicular to the axis (Z) and inclined to the second axis (Y), said lenses (20) being placed along the third axis (Z) in a position where the beams are aligned along the second axis (Y).

9. A device as claimed in claim 4, **characterised in that** the recombining means (8) comprise a plurality of mirrors (25), the normals of which, in advancing along an axis parallel to the second axis (Y), are progressively rotated parallel to the plane defined by the first and third axis (X, Z).

10. A device as claimed in claim 4, **characterised in that** the focusing means are cylindrical lenses (14, 15) positioned in succession along the path of the laser beams (L1, L2, L3).

11. A device as claimed in claim 4, **characterised in that** the focusing means are a cylindrical lens (21) and a spherical lens (22) positioned along the path of the laser beams (L1, L2, L3).

## Patentansprüche

1. Verfahren zur Konditionierung der Lichtemission eines eine Anordnung (2) von Laserdioden umfassenden Lasergenerators (1), um eine Helligkeit entlang einer ersten Achse in der Richtung (X) der Anordnung (2) und entlang einer zweiten Achse in der Richtung (Y) senkrecht dazu auszugleichen, wobei die Konditionierung derart ist, dass sie eine optimale Nutzung des aus dem Zusammensetzen der von den Laserdioden emittierten einzelnen Strahlen (L1, L2, L3) resultierenden Laserstrahls (L) ermöglicht, zum Beispiel für seine optimale Kopplung an eine optische Faser (50), wobei die Laserdioden nebeneinander entlang der ersten Raumachse (X) positioniert sind, senkrecht zu der die einzelnen Laserstrahlen entlang einer dritten Achse (Z) emittiert werden, wobei das Verfahren die folgenden Schritte umfasst:
a) Trennen der von den Laserdioden emittierten Laserstrahlen (L1, L2, L3) durch Ablenken, wobei die Trennung in Nähe zu der Laserdiodenanordnung stattfindet;
b) winkliges Verschieben bezüglich zueinander in der durch die zweite und dritte Achse (Y, Z) definierten Ebene, um wenigstens die von der Laserdiodenanordnung (2) emittierten benachbarten Laserstrahlen (L1, L2, L3) in verschiedene räumliche Ebenen überzuführen;
c) Wiedervereinigen der Strahlen (L1, L2, L3) in verschiedenen Ebenen entlang der zweiten Achse (Y) senkrecht zu der Achse (X), entlang der die Laserdioden liegen, durch derartiges Ablenken der Strahlen, dass die Flächenmittelpunkte der Strahlen entlang der Richtung der zweiten Achse (Y) ausgerichtet sind und sich in parallelen Richtungen ausbreiten; und
d) Kollimieren der Laserstrahlen in einen resultierenden einzelnen Laserstrahl (L),
**dadurch gekennzeichnet, dass** es einen Schritt
e) Kollimieren der Strahlen entlang der Richtung der zweiten Achse (Y) zwischen dem Schritt b) des Überführens und dem Schritt c) des Wiedervereinigens umfasst.

2. Verfahren nach Anspruch 1, **dadurch gekennzeichnet, dass** anschließend an das Wiedervereinigen der von der Laserdiodenanordnung (2) emittierten Laserstrahlen (L1, L2, L3) die Strahlen (L1, L2, L3) entlang der Emissionsrichtung (Z) ausgebreitet werden.

3. Verfahren nach Anspruch 1, **dadurch gekennzeichnet, dass** anschließend an das Wiedervereinigen der von der Laserdiodenanordnung (2) emittierten Laserstrahlen (L1, L2, L3) die Strahlen (L1, L2, L3) entlang einer Richtung senkrecht zu der Emissionsrichtung (Z) ausgebreitet werden.

4. Vorrichtung zur Konditionierung der Lichtemissionen eines Lasergenerators (1), umfassend eine Laserdiodenanordnung (2), welche einen rechteckigen Spatkörper aufweist, der sich hauptsächlich entlang einer Hauptraumachse (X) und in einem geringeren Umfang entlang einer zweiten Achse (Y) senkrecht zu dieser letzteren erstreckt, wobei die Laserstrahlen (L1, L2, L3) von den Dioden entlang einer dritten Achse (Z) senkrecht zu den Achsen (X, Y) emittiert werden, wobei die Vorrichtung für die Laserstrahlen (L1, L2, L3) ein Trenner- und Ablenkmittel (5), welches in Nähe zu der Laserdiodenanordnung (2) positioniert ist und angeordnet ist, die Strahlen winklig zueinander zu verschieben und die Strahlen in verschiedene räumliche Ebenen parallel zu der durch die vorgenannte erste und dritte Achse (X, Z) definierten Ebene überzuführen, und ein Wiedervereinigungsmittel (8) umfasst, welches angeordnet ist, um die Strahlen so abzulenken, dass sich ihre Flächenmittelpunkte entlang einer Achse parallel zu der zweiten Achse ausbreiten, wobei die Laserstrahlen (L1, L2, L3) dann durch Fokussierungsmittel (14, 15; 21, 22; 26, 27) in der Brennebene fokussiert werden,
**dadurch gekennzeichnet, dass** eine Linse (10) zwischen dem Trennermittel (5) und dem Wiedervereinigungsmittel (8) positioniert ist, wobei die Linse (10) eine Brennweite F in der zweiten Richtung (Y) aufweist und in einer Entfernung F von dem Trenner- und Ablenkmittel (5) positioniert ist, um so die von den Laserdioden emittierten Strahlen entlang der zweiten Richtung (Y) zu kollimieren.

5. Vorrichtung nach Anspruch 4, **dadurch gekennzeichnet, dass** das Trenner- und Ablenkmittel eine Linse ist, welche eine von null verschiedene Brechkraft entlang nur einer der Richtungen senkrecht zu der Ausbreitungsachse des Laserstrahls aufweist.

6. Vorrichtung nach Anspruch 5, **dadurch gekennzeichnet, dass** die Linse (6) ihre Symmetrieachse (W) zur durch die erste und die dritte Achse (X, Z) definierten Ebene geneigt hat.

7. Vorrichtung nach Anspruch 4, **dadurch gekennzeichnet, dass** das Wiedervereinigungsmittel (8) eine Mehrzahl von benachbarten plankonvexen zylindrischen Linsen (13) mit positiver Brennweite umfasst, wobei ihre Mitten entlang einer Achse positioniert sind, welche in einer Ebene senkrecht zu der Achse (Z) liegt und schräg zur zweiten Achse (Y) ist, wobei die Linsen (13) entlang der dritten Achse (Z) an einer Stelle platziert sind, wo die Strahlen entlang der zweiten Achse (Y) ausgerichtet sind.

8. Vorrichtung nach Anspruch 4, **dadurch gekennzeichnet, dass** das Wiedervereinigungsmittel (8) eine Mehrzahl von überlagerten plankonkaven zylindrischen Linsen (20) mit negativer Brennweite umfasst, wobei ihre Mitten entlang einer Achse positioniert sind, welche in einer Ebene senkrecht zu der Achse (Z) liegt und schräg zu der zweiten Achse (Y) ist, wobei die Linsen (20) entlang der dritten Achse (Z) an einer Stelle platziert sind, wo die Strahlen entlang der zweiten Achse (Y) ausgerichtet sind.

9. Vorrichtung nach Anspruch 4, **dadurch gekennzeichnet, dass** das Wiedervereinigungsmittel (8) eine Mehrzahl von Spiegeln (25) umfasst, deren Lotrechten, fortschreitend entlang einer Achse parallel zu der zweiten Achse (Y), stufenweise parallel zu der durch die erste und dritte Achse (X, Z) definierten Ebene rotiert sind.

10. Vorrichtung nach Anspruch 4, **dadurch gekennzeichnet, dass** die Fokussierungsmittel nacheinander entlang des Pfads der Laserstrahlen (L1, L2, L3) positionierte zylindrische Linsen (14, 15) sind.

11. Vorrichtung nach Anspruch 4, **dadurch gekennzeichnet, dass** die Fokussierungsmittel eine entlang des Pfads der Laserstrahlen (L1, L2, L3) positionierte zylindrische Linse (21) und sphärische Linse (22) sind.

## Revendications

1. Procédé de conditionnement de l'émission lumineuse d'un générateur laser (1) comprenant une matrice de diodes lasers (2), pour égaliser la luminosité le long d'un premier axe dans la direction (X) de la matrice (2) et le long d'un deuxième axe dans la direction (Y) perpendiculaire à celle-ci, ledit conditionnement étant tel qu'il permet une utilisation optimale du faisceau laser (L) résultant du mélange des faisceaux individuels (L1, L2, L3) émis par lesdites diodes laser, par exemple pour son couplage optimal à une fibre optique (50), lesdites diodes laser étant positionnées côte à côte le long du premier axe spatial (X) perpendiculaire auquel les faisceaux laser individuels sont émis le long d'un troisième axe (Z), le procédé comprenant les étapes suivantes : a) séparation par déflexion des faisceaux lasers (L1, L2, L3) émis par les diodes lasers, ladite séparation ayant lieu à proximité de la matrice de diodes lasers ; b) décalage angulaire réciproque à l'intérieur du plan défini par le deuxième et le troisième axe (Y, Z) pour acheminer au moins les faisceaux lasers adjacents (L1, L2, L3) émis par ladite matrice de diodes lasers (2) dans différents plans spatiaux ; c) recombinaison desdits faisceaux (L1, L2, L3) dans différents plans le long du deuxième axe (Y) perpendiculaire à l'axe (X) le long duquel se trouvent les diodes lasers, en déviant les faisceaux de telle sorte que les axes centraux des faisceaux sont alignés le long de la direction du deuxième axe (Y) et se propagent dans des directions parallèles, et d) collimation desdits faisceaux lasers en un seul faisceau laser résultant (L), **caractérisé en ce qu'**il comprend une étape e) de collimation des faisceaux le long de la direction du deuxième axe (Y) entre ladite étape b) d'acheminement et ladite étape c) de recombinaison.

2. Procédé selon la revendication 1, **caractérisé en ce que**, suite à la recombinaison des faisceaux lasers (L1, L2, L3) émis par la matrice de diodes lasers (2), lesdits faisceaux (L1, L2, L3) se propagent le long de ladite direction d'émission (Z).

3. Procédé selon la revendication 1, **caractérisé en ce que**, suite à la recombinaison des faisceaux lasers (L1, L2, L3) émis par la matrice de diodes lasers (2), lesdits faisceaux (L1, L2, L3) se propagent le long d'une direction perpendiculaire à la direction d'émission (Z).

4. Dispositif de conditionnement de l'émission lumineuse d'un générateur laser (1) comprenant une matrice de diodes lasers (2), ayant un corps en parallélépipède rectangle s'étendant principalement le long d'un axe spatial principal (X) et dans une mesure moindre le long d'un deuxième axe (Y) perpendiculaire à ce dernier, les faisceaux lasers (L1, L2, L3) étant émis par lesdites diodes lasers le long d'un troisième axe (Z), perpendiculaire auxdits axes (X, Y), ledit dispositif comprenant pour lesdits faisceaux lasers (L1, L2, L3), des moyens séparateurs et déflecteurs (5) positionnés à proximité de la matrice de diodes lasers (2) et agencés pour décaler de façon angulaire réciproque lesdits faisceaux et acheminer lesdits faisceaux dans différents plans spatiaux parallèles au plan défini par le premier et le troisième axes (X, Z) susmentionnés, et des moyens de recombinaison (8) agencés pour dévier lesdits faisceaux de telle sorte que leurs axes centraux se propagent côte à côte le long d'un axe parallèle au deuxième axe, lesdits faisceaux lasers (L1, L2, L3) étant ensuite focalisés par des moyens de focalisation (14, 15 ; 21, 22 ; 26, 27) dans le plan focal, **caractérisé en ce qu'**une lentille (10) est positionnée entre les moyens séparateurs (5) et les moyens de recombinaison (8) ; ladite lentille (10) ayant une longueur focale F dans la deuxième direction (Y) et étant positionnée à une distance F à partir desdits moyens séparateurs et déflecteurs (5) de telle sorte à collimater le long de la deuxième direction (Y) les faisceaux émis par les diodes lasers.

5. Dispositif selon la revendication 4, **caractérisé en ce que** les moyens séparateurs et déflecteurs sont une lentille ayant une puissance dioptrique différente de zéro le long d'une seule des directions perpendiculaires à l'axe de propagation du faisceau laser.

6. Dispositif selon la revendication 5, **caractérisé en ce que** la lentille (6) a son axe de symétrie (W) incliné par rapport au plan défini par les premier et troisième axes (X, Z).

7. Dispositif selon la revendication 4, **caractérisé en ce que** les moyens de recombinaison (8) comprennent une pluralité de lentilles cylindriques planes-convexes adjacentes (13) de longueur focale positive avec leurs centres positionnés le long d'un axe se trouvant dans un plan perpendiculaire à l'axe (Z) et incliné par rapport au deuxième axe (Y), lesdites lentilles (13) étant placées le long du troisième axe (Z) dans une position où les faisceaux sont alignés le long du deuxième axe (Y).

8. Dispositif selon la revendication 4, **caractérisé en ce que** les moyens de recombinaison (8) comprennent une pluralité de lentilles cylindriques planes-concaves superposées (20) de longueur focale négative avec leurs centres positionnés le long d'un axe se trouvant dans un plan perpendiculaire à l'axe (Z) et incliné par rapport au deuxième axe (Y), lesdites lentilles (20) étant placées le long du troisième axe (Z) dans une position où les faisceaux sont alignés le long du deuxième axe (Y).

9. Dispositif selon la revendication 4, **caractérisé en ce que** les moyens de recombinaison (8) comprennent une pluralité de miroirs (25), dont les perpendiculaires, en progressant le long d'un axe parallèle au deuxième axe (Y), sont tournées progressivement parallèlement au plan défini par les premier et troisième axe (X, Z).

10. Dispositif selon la revendication 4, **caractérisé en ce que** les moyens de focalisation sont des lentilles cylindriques (14, 15) positionnées successivement le long de la trajectoire des faisceaux laser (L1, L2, L3).

11. Dispositif selon la revendication 4, **caractérisé en ce que** les moyens de focalisation sont une lentille cylindrique (21) et une lentille sphérique (22) positionnées le long de la trajectoire des faisceaux laser (L1, L2, L3).
